# EUROPÄISCHE PATENTSCHRIFT

(11) **EP 2 569 361 B1**
(45) Veröffentlichungstag und Bekanntmachung des Hinweises auf die Patenterteilung: **16.04.2014**
(21) Anmeldenummer: 11718385.5
(22) Anmeldetag: 06.05.2011
(51) Int. Cl.: C08K 5/134, C08J 5/18, B32B 17/10

(54) **PVB-FOLIE MIT PHENOLISCHEN ANTIOXIDANTIEN DER TEILSTRUKTUR 3-T-BUTYL-4-HYDROXY-5-METHYLPHENYLPROPRIONAT**
PVB FILM COMPRISING PHENOLIC ANTIOXIDANTS HAVING THE PARTIAL STRUCTURE 3-T-BUTYL-4-HYDROXY-5-METHYLPHENYL PROPRIONATE
FEUILLE EN PVB À ANTIOXYDANTS PHÉNOLIQUES DE STRUCTURE PARTIELLE 3-T-BUTYL-4-HYDROXY-5-MÉTHYLPHÉNYLPROPRIONATE

(30) Priorität: 11.05.2010 DE 102010028855
(43) Veröffentlichungstag der Anmeldung: 20.03.2013
(73) Patentinhaber: Kuraray Europe GmbH, 65795 Hattersheim (DE)
(72) Erfinder: KELLER, Uwe, 53177 Bonn (DE)
(74) Vertreter: Kisters, Michael Marcus
(86) Internationale Anmeldenummer: PCT/EP2011/057329
(87) Internationale Veröffentlichungsnummer: WO 2011/141384

(56) Entgegenhaltungen:
- WO-A1-2009/090827
- DE-C1- 4 215 141
- US-A1- 2004 234 778
- DATABASE WPI Week 199340 Thomson Scientific, London, GB; AN 1993-314501 XP002641027, -& JP 5 224343 A (MITSUBISHI KASEI CORP) 3. September 1993 (1993-09-03) -& DATABASE CA [Online] CHEMICAL ABSTRACTS SERVICE, COLUMBUS, OHIO, US; 9. Juli 1994 (1994-07-09), ITO, HITOSHI ET AL: "Photochromic glass laminates", XP002641028, gefunden im STN Database accession no. 1994:422646
- DATABASE WPI Week 200864 Thomson Scientific, London, GB; AN 2008-K78121 XP002641118, -& JP 2008 195557 A (BRIDGESTONE CORP) 28. August 2008 (2008-08-28)

## Beschreibung

### Technisches Gebiet

Die Erfindung betrifft extrudierte Folien mit geringer Eigenfarbe und hoherphotothermischer aus thermoplastischen Mischungen von weichmacherhaltigen Polyvinylacetalen durch Verwendung besonders geeigneter phenolischer Antioxidantien.

### Stand der Technik

Wie viele andere Thermoplaste wird Polyvinylbutyral häufig mit phenolischen Antioxidantien (phenolische AO) ausgerüstet, deren Aufgabe es ist, z.B. bei der Folienextrusion durch hohe Verarbeitungstemperaturen ausgelöste radikalische Spaltungsreaktionen zu unterbinden. Hierdurch wird die Länge der Polymerketten im Wesentlichen konstant gehalten, so dass die mechanischen Eigenschaften des extrudierten Materials als Folge des Extrusionsvorganges nicht verschlechtert werden.

Viele phenolische Antioxidantien bringen jedoch den Nachteil mit sich, je nach Extrusionsbedingungen eine Gelbfärbung zu verursachen, welche auf Reaktionsprodukte der Antioxidantien zurückzuführen ist. Auch in einer fertigen, bereits zwischen zwei Glasscheiben verklebten PVB-Folie können phenolische Antioxidantien unter UV-Bestrahlung - insbesondere bei erhöhter Temperatur - nachträglich eine Vergilbung verursachen, welche nicht nur aus ästhetischen Gründen unerwünscht ist, sondern auch die Lichttransmission des Glaslaminates mit der Zeit reduziert.

Beispielsweise zeigen sich die in WO 03/078160 A1 (Du Pont) für PVB-Folie mit dem Weichmacher 3G8 bevorzugten zweikernigen phenolischen Antioxidantien wie etwa Lowinox 44B25 und 22M46 als relativ stark unter UV-Bestrahlung vergilbend.

Einige Antioxidantien, wie zum Beispiel BHT (CAS-Reg.Nr.: 128-37-0), sind zwar UV-stabil, jedoch aufgrund ihres geringen Molekulargewichtes relativ flüchtig, so dass in der nicht vom Glas bedeckten Foliensubstanz entlang der Kante des Laminates eine vorzeitige Verarmung des Antioxidants stattfinden kann und die Polymerketten an diesen Stellen der Folie nicht länger gegen Kettenabbau geschützt sind. Zusätzlich weist BHT den Nachteil auf, dass bei erhöhter Temperatur und Zutritt von Luftsauerstoff intensiv gelb gefärbte Reaktionsprodukte entstehen können. Dies kann sich als Mangel bei der Anwendung als Verbundsicherheitsglas oder Photovoltaikmodul in Form von Gelbfärbung der PVB-Folie im Randbereich des Laminates nach dem Autoklavprozeß oder Beständigkeitsprüfungen manifestieren.

### Aufgabe

Aufgabe der vorliegenden Erfindung war es, ein speziell den hohen Anforderungen bei der Herstellung von Folien aus weichmacherhaltigen Polyvinylacetalen durch Extrusion geeignetes phenolisches Antioxidants zu identifizieren, welches für optische Anwendungen einsetzbar ist, d.h. an der laminierten Folie keine Kantenvergilbung, keine unakzeptable Erhöhung des Gelbwertes bei der Extrusion und eine besonders gute photothermische Stabilität zeigt.

### Lösung der Aufgabe

Überraschenderweise wurde gefunden, dass durch Verwendung von phenolischen Antioxidantien die Einheiten von 3-t-Butyl-4-hydroxy-5-methylphenylproprionaten als Teilstruktur aufweisen Folien aus weichmacherhaltigem Polyvinylacetal mit geringer Eigenfarbe und besonders hoher photothermischer Stabilität erhalten werden können.

Gegenstand der vorliegenden Erfindung sind daher Folien aus thermoplastischen Mischungen enthaltend mindestens ein Polyvinylacetal und mindestens einen Weichmacher, gekennzeichnet durch den Zusatz von 0,001 bis 1 Gew.% mindestens einer Verbindung der Formel 1 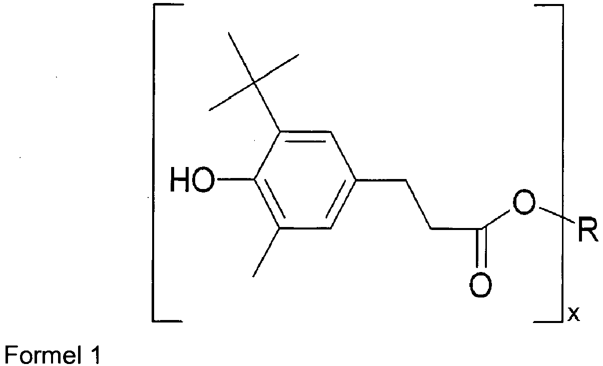 mit R= Kohlenwasserstoffradikal eines polyfunktionellen Alkohols, Oligoglykole mit 1 bis 10 Glykoleinheiten oder Kohlenwasserstoffrest mit 1 bis 20 Kohlenstoffatomen sowie X= 1, 2, 3 oder 4 als Stabilisator und Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht, wobei die Folie eine Eigenfarbe DYI von weniger als 5 aufweist.

Geeignete Stabilisatoren der Formel 1 solche zum Beispiele solche der Formel 1 a 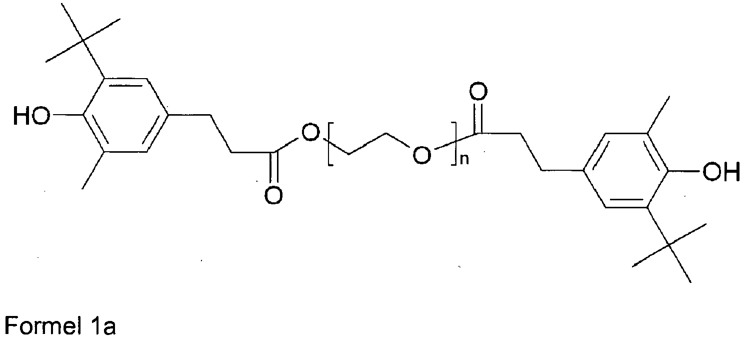 mit n=1 bis 10 oder solche der Formel 1 b

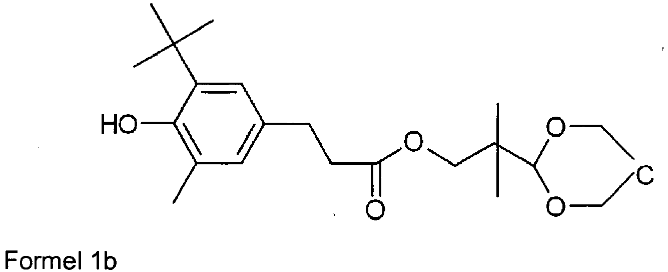

Weiterer Gegenstand ist die Verwendung von Verbindungen gemäß Formel 1, 1a oder 1b als Stabilisator für thermoplastische Mischungen aus mindestens einem Weichmacher und mindestens einem Polyvinylacetal.

Geeignete Stabilisatoren gemäß Formel 1, 1a oder 1b sind solche der CAS-Reg.Nr. 36443-68-2, welche beispielsweise von der Firma CIBA als IRGANOX 245, von der Firma CHEMTURA als Lowinox GP45 oder von der Firma SONGWON als Songnox 2450 sowie solche der CAS-Reg.Nr. 90498-90-1 die unter dem Namen SUMILIZER GA 80 von der Firma Sumimoto erhältlich sind.

Erfindungsgemäße Mischungen oder Folien enthalten bevorzugt 0,005 - 0,5 Gew.-%, besonders bevorzugt 0,01 - 0,25 Gew.-%, insbesondere 0,02 - 0,1 Gew.-% und am meisten bevorzugt 0,03 - 0,08 Gew.-% der phenolischen Antioxidantien mit der Teilstruktur 3-t-Butyl-4-hydroxy-5-methylphenylproprionat gemäß Formel 1.

Zusätzlich zur Verwendung der Stabilisatoren gemäß Formel 1, 1a oder 1 b kann die Einstellung eines geringen Alkalititers der erfindungsgemäßen Mischung z.B. bei der Neutralisation des Polyvinylacetal verbesserte Eigenfarbe und photothermische Stabilität der erfindungsgemäßen Mischung oder Folie bewirken.

Der Alkalititer wird, wie in den Beispielen angegeben, durch Neutralisation der erfindungsgemäßen Mischung bzw. Folie mit Salzsäure bestimmt und liegt bevorzugt zwischen 2 und 70, insbesondere zwischen 3 und 50 und am meisten bevorzugt zwischen 5 und 30.

Die Einstellung des Alkalititers kann durch entsprechende Neutralisation des Polyvinylacetals während oder nach dessen Herstellung durch Acetalisierung von Polvinylalkohol erfolgen oder durch Zugabe von Metallsalzen zur erfindungsgemäßen Mischung. Die Metallsalze fungieren bei der Verwendung der erfindungsgemäßen Folien für Verbundglaslaminate in der Regel auch als Antihaftmittel.

Besonders geeignet für die erfindungsgemäße Mischung sind Polyvinylacetale, erhältlich als Acetalisierungsprodukte von Polyvinylalkohol PVA mit Butyraldehyd, d.h. Polyvinylbutyral (PVB). Erfindungsgemäße Mischungen können ein oder mehrere Polyvinylacetale enthalten, die sich in Molgewicht, Acetalisierungsgrad, Restalkoholgehalt oder Natur der Acetalgruppe unterscheiden können.

Erfindungsgemäße Mischungen oder Folien können als Antihaftmittel Erdalkalimetall-, Zink-, Aluminium- bzw. Alkalimetallionen enthalten. Diese liegen in der Mischung/Folie in Form der Salze von ein- oder mehrwertigen anorganischen oder ein- oder mehrwertigen organischen Säuren vor. Beispiele für Gegenionen sind z.B. Salze organischer Carbonsäuren wie etwa Formiate, Acetate, Trifluoracetate, Propionate, Butyrate, Benzoate, 2-Ethylhexanoate usw., wobei bevorzugt Carbonsäuren mit weniger als 10 C-Atomen, bevorzugt weniger als 8, bevorzugt weniger als 6, bevorzugt weniger als 4 und besonders bevorzugt mit weniger als 3 C-Atomen verwendet werden. Beispiele für anorganische Gegenionen sind Chloride, Nitrate, Sulfate, Phosphate. Weitere Gegenionen können den Tensiden zuzurechnende Anionen sein, wie etwa Sulfonate oder Phosphatische Tenside.

Weiterhin können die genannten günstigen optischen Eigenschaften der erfindungsgemäßen Mischung durch Selektion des zur Herstellung des Polyvinylacetals herangezogenen Polyvinylalkohol (PVA) verbessert werden. Liegen auf Stufe des PVA ungesättigte Einheiten in der Polymerkette als Fehlstellen vor, finden sich diese zwangsläufig auch im daraus erzeugten Polyvinylacetal wieder wodurch sich dessen Absorption von UV-Strahlung erhöht und Lichtstabilität verschlechtert. Die ungesättigten Einheiten können in Form von isolierten oder in Konjugation zueinander oder in Konjugation zu Carbonylbindungen stehenden Doppelbindungen vorliegen. Diese ungesättigten Einheiten lassen sich durch UV-Spektroskopie im PVA nachweisen.

Sehr hohe Anteile an Fehlstellen führen bei Messung des eingesetzten PVA in 4 Gew.%-iger Lösung in H₂O zu Extinktionen bei 280 nm von nahe 1. Zur Herstellung von erfindungsgemäß verwendetem Polyvinylacetal werden daher bevorzugt Polyvinylalkohole eingesetzt, die in einer 4 Gew.% wässrigen Lösung bei 280 nm Extinktionswerte von weniger als 0.5, von weniger als 0.3, insbesondere 0.2 und bevorzugt 0.1 aufweist.

Wegen ihrer guten photothermischen Eigenstabilität sind zusätzlich als UV-Absorber Verbindungen vom Benzotriazol-Typ, insbesondere die Typen Tinuvin 328, 327 und 326 geeignet. Die vorliegende Erfindung schließt die Verwendung von Benzotriazolen ausdrücklich mit ein. Hiermit hergestellte Folien weisen zwar eine höhere Eigenfarbe auf, besitzen jedoch auch besonders geringe delta b* Werte nach Bestrahlungsprüfung.

Ebenfalls zusätzlich zur Verwendung der phenolischen Antioxidantien mit der Teilstruktur 3-t-Butyl-4-hydroxy-5-methylphenylproprionat gemäß Formel 1 und anstelle oder zusätzlich zu den o.g. flüchtigen Antioxidantien können die erfindungsgemäßen Mischungen bzw. Folien mit einem oder mehreren nicht-aromatischen Lichtstabilisatoren, insbesondere mit 0,001 bis 1 Gew.% (bezogen auf die Folienmischung) sterisch gehinderten Aminen vom Typ HAS / HALS / NOR-HALS (sterisch gehinderten Aminoethern) ausgerüstet werden, wodurch sich eine weitere Verbesserung der photothermischen Stabilität erreichen lässt.

Besonders geeignete nicht-aromatische Lichtstabilisatoren sind sterisch gehinderte Amine der allgemeinen Formeln II, III und/oder IV 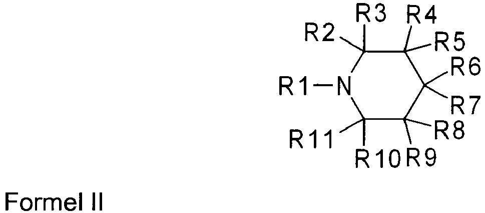 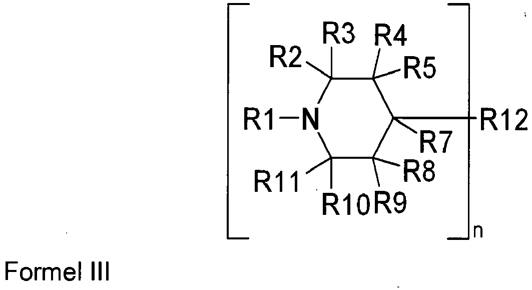 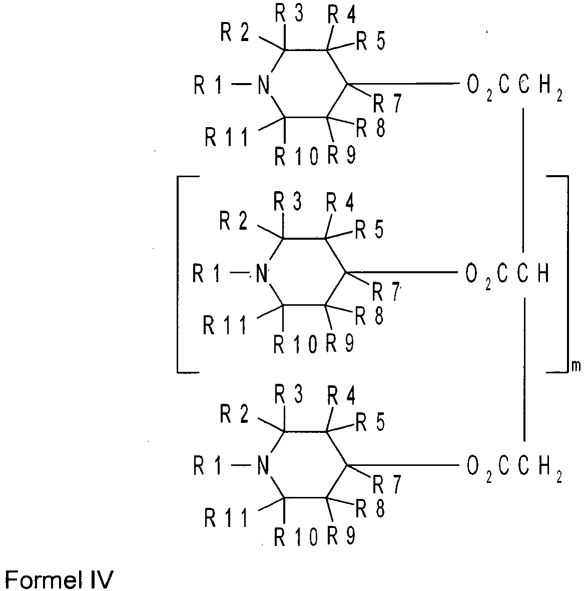 mit R1, R2, R3, R4, R5, R6, R7, R8, R9, R10, R11 = nicht-aromatische Substituenten wie H, C1 - C20 Alkyl, Hydroxyalkyl, Alkoxyalkyl, Acyloxyalkyl, jeweils unsubstituiert oder durch Aldehyd-, Keto- oder Epoxidgruppen substituiert
R12 = glatte Verbindung, C1 - C20 Alkyl, Hydroxyalkyl, Alkoxyalkyl, Acyloxyalkyl, jeweils unsubstituiert oder durch Aldehyd-, Keto- oder Epoxidgruppen substituiert
n = 2 - 4
m = 1 - 10.

Verbindungen dieser Art sind kommerziell erhältlich, geeignet sind beispielsweise Tinuvin 123 (NOR-HALS), Tinuvin 144, Tinuvin 622, Tinuvin 770 und dessen Di-N-methyliertes Derivat, der Fa. Ciba Specialities. Besonders gut geeignet sind ADK Stab LA-57, LA-52 oder LA-62 der Fa. Asahi Denka Co. oder UVINUL 4050 H der BASF AG.

Zusätzlich zur Verwendung der phenolischen Antioxidantien mit der Teilstruktur 3-t-Butyl-4-hydroxy-5-methylphenylproprionat gemäß Formel 1 können die thermoplastischen Mischungen/Folien eine Grundstabilisierung mit einem weiteren photostabilen, aufgrund anderer Eigenschaften, wie etwa hoher Flüchtigkeit, für sich alleine genommen weniger geeignetem phenolischen Antioxidants enthalten. Im Rahmen der vorliegenden Erfindung sind damit Antioxidantien mit einer erhöhten Flüchtigkeit unter den Extrusions- und Verarbeitungsbedingungen von PVB-Folie gemeint, was auf phenolische Antioxidantien mit einem Molekulargewicht von weniger als 300 g/mol in der Regel zutrifft. Diese zusätzlichen phenolische Antioxidantien können anstelle oder in Kombination mit den genannten sterisch gehinderten Aminen vom Typ HAS / HALS / NOR-HALS verwendet werden. Bevorzugt enthalten die erfindungsgemäßen thermoplastische Mischung bzw. Folien phenolische Antioxidantien mit einem Molekulargewicht von weniger als 300 g/mol in einer Menge von 0.001 - 0.25 Gew.-% (bezogen auf die Folienmischung). Besonders geeignete phenolische Antioxidantien sind BHT (CAS-Reg.Nr.: 128-37-0) oder 4-tert-Octylphenol (CAS-Reg.Nr.: 140-66-9).

Die sterisch gehinderten phenolischen Antioxidantien mit der Teilstruktur 3-t-Butyl-4-hydroxy-5-methylphenylproprionat der Formel 1 sowie ggf. die weiteren Antioxidantien können in verschiedener Weise in die erfindungsgemäße Mischung bzw. die damit hergestellte Folie eingebracht werden. Sie können vor der Extrusion bereits im Polymer enthalten sein oder während der Extrusion bzw. auf Stufe der Blendherstellung im Weichmacher gelöst oder suspendiert zugegeben werden. Bevorzugt werden die phenolischen Antioxidantien bereits auf der Stufe der PVB-Synthese eingebracht, z.B. durch Aufsprühen auf die fertigen Polymerpartikel oder während der Fällung des PVB-Polymers aus der Reaktionslösung. Entsprechendes gilt für die Zugabe der sterisch gehinderten aminischen Lichtstabilisatoren, wobei diese bevorzugt im Weichmacher gelöst zugegeben werden.

Bevorzugt weisen die Folien einen Gesamtweichmachergehalt d.h. der Anteil aller Weichmacher in der Folie im Bereich von 5 - 45 Gew.%, 12 - 36 Gew.%, 14 - 32 Gew.%, 16 - 30 Gew.%, insbesondere 20 - 28 Gew.% auf. Erfindungsgemäße Folien bzw. damit verklebte Laminate können einen oder mehrere Weichmacher enthalten.

Grundsätzlich geeignete Weichmacher für die erfindungsgemäßen Mischungen oder Folien sind eine oder mehrere Verbindungen ausgewählt aus den folgenden Gruppen:

Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyladipaten, Diisononyladipat, Heptylnonyl-adipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat

Ester oder Ether von mehrwertigen aliphatischen oder aromatischen Alkoholen oder Oligoetherglykolen mit einem oder mehreren unverzweigten oder verzweigten aliphatischen oder aromatischen Substituenten, wie z.B. Estern von Di-, Tri- oder Tetraglykolen mit linearen oder verzweigten ali-phatischen oder cycloaliphatischen Carbonsäuren;
Als Beispiele für letztere Gruppe können dienen
Diethylenglykol-bis-(2-ethyl-hexanoat),
Triethylenglykol-bis-(2-ethyl-hexanoat),
Tri-ethylen-glykol-bis-(2-ethylbu-ta-no-at),
Tetra-ethylen-glykol-bis-n-heptanoat, Triethylengly-kol-bis-n-heptanoat, Triethylenglykol-bis-n-hexanoat, Tetraethylen-glykol-dimethyl-ether und/oder Dipropylenglykolbenzoat

Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat

Ester der Zitronensäure, Bernsteinsäure und/oder Fumarsäure.

Gut geeignet als Weichmacher für die erfindungsgemäßen Mischungen oder Folien sind eine oder mehrere Verbindungen ausgewählt aus der folgenden Gruppe Di-2-ethylhexylsebacat (DOS), Di-2-ethylhexyladipat (DOA), Dihexyladipat (DHA), Dibutylsebacat (DBS), Diisononyladipat (DINA), Triethylenglykol-bis-2-ethylhexanoat (3GO bzw. 3G8) Tetraethylenglykol-bis-n-2-ethylhexanoat (4GO bzw. 4G8) Di-2-butoxy-ethyl-adipat (DBEA), Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), und 1,2-Cyclohexandicarbonsäurediisononylester (DINCH).

Diese sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

**Tabelle 1**

| Name | Abkürzung | 100 x O/(C+H) |
|---|---|---|
| Di-2-ethylhexylsebacat | (DOS) | 5,3 |
| Di-isononylad ipat | (DINA) | 5,3 |
| 1,2-Cyclohexandicarbonsäurediisononylester | (DINCH) | 5,4 |
| Di-2-ethylhexyladipat | (DOA) | 6,3 |
| Dihexyladipat | (DHA) | 7,7 |
| Dibutylsebacat | (DBS) | 7,7 |
| Triethylenglykol-bis-2-propylhexanoat | | 8,6 |
| Triethylenglykol-bis-i-nonanoat | | 8,6 |
| Di-2-butoxyethylsebacat | (DBES) | 9,4 |
| Triethylenglykol-bis-2-ethylhexanoat | (3G8) | 9,4 |

Weiterhin können die erfindungsgemäßen Mischungen oder Folien zusätzlich weitere Additive, wie zum Beispiel Antistatika, Füllstoffe, IR-Absorbierende Nanopartikel bzw. Chromophore, Farbstoffe, oberflächenaktive Substanzen, Chelatbildner, Epoxygruppen enthaltende Verbindungen, Pigmente sowie Haftungsregulatoren enthalten.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Erfindungsgemäße thermoplastische Mischungen können in üblicher Weise bei ca. 160 bis 230 °C zu Folie extrudiert werden. Solche Folien weisen bevorzugt einen DYI von weniger als 5, besonders bevorzugt weniger als 4 und insbesondere weniger als 3 und einen delta b*-Wert von weniger als 3, bevorzugt weniger als 2,5, besonders bevorzugt weniger als 2 und insbesondere weniger als 1,5 auf.

Die erfindungsgemäßen Folien können zur Herstellung von Verbundglaslaminaten, Windschutzscheiben oder Photovoltaikmodulen verwendet werden.

### Prüf- und Messmethoden:

Die Bestrahlungsbeständigkeit der Folien wurde im Verbundglas zwischen zwei Gläsern der Stärke 2 mm des Typs Optiwhite® (Eisenoxidarmes Glas der Firma Pilkington mit im Vergleich zu typischem Klarglas erhöhter Durchlässigkeit für UV-A Strahlung) getestet. Dabei wurden Laminate mit Abmessung 15 x 15 cm in der Bestrahlungskammer gemäß EN 12543 über einen Zeitraum von 20 Wochen ausgelegt. Abweichend von den Bedingungen der EN 12543 wurde eine höhere Probetemperatur von konstant 80 °C eingestellt, da dies eher einer in der Anwendung im ungünstigen Fall tatsächlich vorkommenden kombinierten Strahlungs- und Temperaturbelastung entspricht.

Durch vergleichende Messung des b*-Wertes (CIELab) des bestrahlten Laminates gegen ein dunkel gelagertes Originallaminat kann leicht die relative Zunahme des b*-Wertes als Maß für die Strahlungsbeständigkeit der PVB-Folie mit dem jeweiligen Stabilisatortyp bzw. der jeweiligen Stabilisatorkombination ermittelt werden. Die Messung des b*-Wertes erfolgte auf einem Farbmessgerät "ColorQuest XE" des Herstellers Hunterlab im CIELAb-System in Transmission (10°/D65). Der delta b*-Wert ergibt sich als Differenz zwischen b*-Wert der bestrahlten Probe und dem b*-Wert der Originalprobe.

Zwecks besserer Differenzierung der Eigenfarbe der extrudierten Folie (ohne zusätzliche Belastung durch Bestrahlung) wird ein Verbundglas mit 10 Lagen Folie in Stärke 0.76 mm (Gesamtfoliendicke also 7,6 mm) mit zwei Scheiben Klarglas (2 mm Planilux®) - auf dem ColorQuest XE nach folgendem Verfahren gemessen. Bei dem Verfahren wird die Eigenfarbe des Glases durch Einmessens des Scheibenpärchens der identischen Glascharge als Nullprobe herausgemittelt. Die Berechnung des Yellowness Index (YI [D1925]) erfolgt automatisch gemäß Bedingungen Hunterlab 2°/Lichtart C. Der Wert DYI ist die Differenz aus YI (Laminat 10 x 0.76) - YI (Glaspaar).

Die Thermooxidative Stabilität (Kantenstabilität) wird an Testlaminaten aus 2 x 3 mm Floatglas der Abmessung 15 x 15 cm bewertet. Nach einem üblichen Walzenvorverbundschritt werden die Testlaminate zur Herstellung des Endverbundes einem verlängertem und heißem Autoklavenprozess unterworfen, welcher bei einer Gesamtdauer von 6h eine Haltezeit von 3h bei 160 °C und 12 bar umfasst. Als Ergebnis der thermooxidativen Belastung und als Funktion der gewählten Stabilisierungsvariante verfärbt sich hierbei die an der Kante des Testlaminates befindliche Folienmasse innerhalb einer Bandbreite von "gar nicht" bis "dunkel bernsteinfarben". Ersterem wird die Note 0, letzterem die Note 6 mit entsprechenden dazwischen befindlichen Einstufungen zugeordnet.

Der Polyvinylalkohol- und Polyvinylalkoholacetatgehalt der Polyvinylacetale wurde gemäß ASTM D 1396-92 bestimmt. Die Analyse des Metallionengehaltes erfolgte durch Atomabsorptionsspektroskopie (AAS). Der Wasser- bzw. Feuchtegehalt der Folien wird mit der Karl-Fischer-Methode bestimmt.

Zur Bestimmung der UV-Absorption des in der Acetalisierung eingesetzten Polyvinylalkohols wird dieser in einem UV/VIS-Spektrometer, z.B. Perkin-Elmer Lambda 910, als 4%-ige wässrige Lösung in einer Schichtdicke von 1 cm bei der Wellenlänge 280 nm vermessen. Dabei ist der Messwert auf den Trockenstoffgehalt des PVA zu beziehen.

Zur Bestimmung des Alkali-Titers werden 3 bis 4 gr. des weichmacherhaltigen Polyvinylacetal-Films in 100 ml einer Mischung von Ethanol/THF (80:20) in einem Magnetrührer über Nacht gelöst. Hierzu werden 10 ml einer verdünnten Salzsäure (c=0,01 mol/Liter) gegeben und anschließend potentiometrisch mit einer Lösung von Tetrabutylammoniumhydroxid (TBAH) in 2-Propanol (c=0,01 mol/Liter) mit einem Titroprozessor gegen eine Leerprobe potentiometrisch titriert. Der Alkali-Titer berechnet sich wie folgt:

Alkali-Titer = ml HCl pro 100 gr einer Probe = (Verbrauch TBAH Leerprobe - TBAH Probe x 100 durch Gewicht der Probe in gr.)

### Beispiele

Es wurden die in den folgenden Tabellen angegebenen Mischungen auf einem Extruder mit einem Durchsatz von 85 kg/h und bei einer Massetemperatur von 200°C zu Folien der Dicke 0.76 mm extrudiert. Alle Angaben in Gew.-%, bezogen auf Folienmischung soweit nicht anders angegeben.

Es bedeuten
- Wassergehalt: Wassergehalt der Folienmischung zum Zeitpunkt der Lamination
- PVA: PVA-Gehalt des PVB in Gew% bz. Auf PVB
- Extinktion: Extinktion des PVA bei 280 nm
- MgAc: Magnesiumacetat tetrahydrat
- Tinuvin 328: UV-Absorber Benzotriazol-typ
- Tinuvin 770: HALS, Fa. Ciba Specialities.
- Songnox 2450: Firma Songwon, erfindungsgemäßer Stabilisator
- Sumilizer GA-80: Firma Sumimoto, erfindungsgemäßer Stabilisator
- BHT: Phenolisches Antioxidants mit Molekulargewicht kleiner 300 g/mol
- Lowinox 44B25: Phenolisches Antioxidants, nicht erfindungsgemäß
- Irganox 1076: Phenolisches Antioxidants, nicht erfindungsgemäß

Die Zusammensetzungen der Beispiel 2, 4 und 7 weisen zusätzlich zu einem erfindungsgemäßen Stabilisator ein Antioxidants mit einem Molgewicht kleiner 300 g/mol auf; Beispiel 5 zeigt noch einen HALS Stabilisator.

Vergleichsbeispiele 1 und 2 weisen nur übliche Stabilisatoren und keinen erfindungsgemäßen Stabilisator mit der Teilstruktur der Formel 1, 1a oder 1 b auf. Neben einer deutlich 'verschlechterten thermooxidativen Stabilität (VglB1) zeigen die Folien unakzeptable Verfärbungen, ausgedrückt über den delta b* und DYI-Wert.

**Tabelle 2**

| **Zusammensetzung der Folie** | **Bsp.1** | **Bsp.2** | **Bsp.3** |
|---|---|---|---|
| PVB | 72,5 | 72,5 | 72,5 |
| PVA | 20,1 | 20,1 | 20,1 |
| Extinktion | < 0,5 | < 0,5 | < 0,5 |
| 3G8 | 25 | 25 | 25 |
| DBEA | 2,5 | 2,5 | 2,5 |
| DINCH | - | - | - |
| DINA | - | - | - |
| MgAc | 0,0125 | 0,0125 | 0,0125 |
| Tinuvin 328 | 0,15 | 0,15 | 0,15 |
| Tinuvin 770 | - | - | - |
| Songnox 2450 | 0,12 | 0,04 | - |
| Sumilizer GA-80 | - | - | 0,12 |
| BHT | - | 0,06 | - |
| Lowinox 44B25 | - | - | - |
| Irganox 1076 | - | - | - |
| Prüfergebnisse an Folie / im Laminat | | | |
| Wassergehalt | 0,44 | 0,45 | 0,44 |
| Alkalititer | 14 | 13 | 14 |
| DYI | 2,4 | 2,3 | 2,5 |
| delta b* | 1,1 | 1,0 | 0,7 |
| Thermooxidative Stabilität | 2 | 1 | 0 |

**Tabelle 3**

| **Zusammensetzung der Folie** | **Bsp.4** | **Bsp.5** | **Bsp.6** |
|---|---|---|---|
| PVB | 72,5 | 72,5 | 74 |
| PVA | 20,1 | 20,1 | 15,2 |
| Extinktion | < 0,5 | < 0,5 | < 0,5 |
| 3G8 | 25 | 25 | - |
| DBEA | 2,5 | 2,5 | - |
| DINCH | - | - | 13 |
| DINA | - | - | 13 |
| MgAc | 0,0125 | 0,0125 | 0,0125 |
| Tinuvin 328 | 0,15 | - | 0,15 |
| Tinuvin 770 | - | 0,075 | - |
| Songnox 2450 | - | 0,12 | 0,12 |
| Sumilizer GA-80 | 0,04 | - | |
| BHT | 0,06 | - | - |
| Lowinox 44B25 | - | - | - |
| Irganox 1076 | - | - | - |
| Prüfergebnisse an Folie / im Laminat | | | |
| Wassergehalt | 0,45 | 0,44 | 0,44 |
| Alkalititer | 13 | 28 | 15 |
| DYI | 2,3 | 1,4 | 2,0 |
| delta b* | 0,8 | 0,5 | 0,8 |
| Thermooxidative Stabilität | 0 | 2 | 0 |

**Tabelle 4**

| **Zusammensetzung der Folie** | **Bsp.7** | **VglB1** | **VglB2** |
|---|---|---|---|
| PVB | 74 | 72,5 | 72,5 |
| PVA | 15,2 | 20,1 | 20,1 |
| Extinktion | < 0,5 | < 0,5 | < 0,5 |
| 3G8 | | 25 | 25 |
| DBEA | | 2,5 | 2,5 |
| DINCH | 13 | - | - |
| DINA | 13 | - | - |
| MgAc | 0,0125 | 0,0125 | 0,0125 |
| Tinuvin 328 | 0,15 | 0,15 | 0,15 |
| Tinuvin 770 | - | | - |
| Songnox 2450 | 0,04 | | - |
| Sumilizer GA-80 | - | - | - |
| BHT | 0,06 | - | - |
| Lowinox 44B25 | - | - | 0,12 |
| Irganox 1076 | - | 0,12 | - |
| Prüfergebnisse an Folie / im Laminat | | | |
| Wassergehalt | 0,42 | 0,45 | 0,44 |
| Alkalititer | 14 | 14 | 13 |
| DYI | 1,8 | 7,8 | 3,2 |
| delta b* | 0,9 | 7,9 | 5,5 |
| Thermooxidative Stabilität | 1 | 6 | 0 |

## Patentansprüche

1. Folie aus einer thermoplastischen Mischung enthaltend mindestens ein Polyvinylbutyral und mindestens einen Weichmacher, **gekennzeichnet durch** den Zusatz von 0,001 bis 1 Gew.% mindestens einer Verbindung gemäß Formel 1 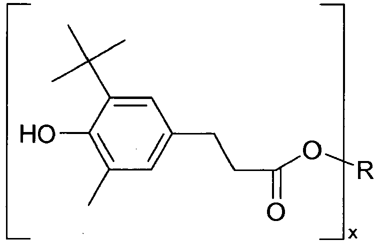
mit R= Kohlenwasserstoffradikal eines polyfunktionellen Alkohols, bifunktionellem cyclischem Ether, bifunktionellem cyclischem Diether, bifunktionellem Dioxanderivat, Oligoglykole mit 1 bis 10 Glykoleinheiten oder Kohlenwasserstoffrest mit 1 bis 20 Kohlenstoffatomen und X= 1, 2, 3 oder 4 als Stabilisator
und Weichmacher, deren Polarität, ausgedrückt **durch** die Formel 100 x O/(C+H) kleiner/gleich 9.4 ist, wobei O, C und H für die Anzahl der Sauerstoff- , Kohlenstoff- und Wasserstoffatome im jeweiligen Molekül steht,
wobei die Folie eine Eigenfarbe DYI von weniger als 5 aufweist bestimmt nach der Methode der Beschreibung).

2. Folie nach Anspruch 1, **dadurch gekennzeichnet, dass** als Stabilisator der Formel 1 solche der Formel 1a 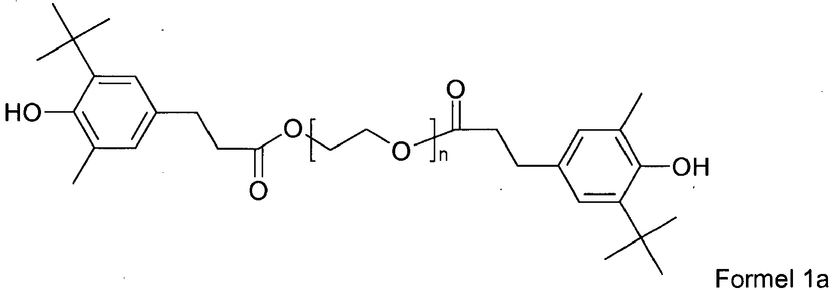 mit n=1 bis 10 eingesetzt werden.

3. Folie nach Anspruch 1, **dadurch gekennzeichnet, dass** als Stabilisator der Formel 1 solche der Formel 1 b 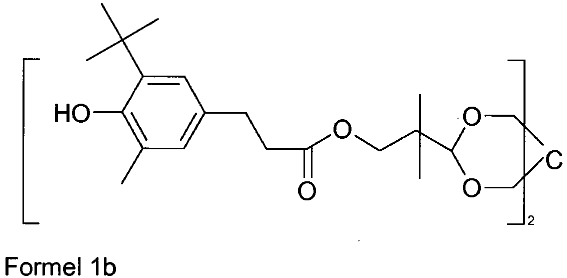 eingesetzt werden.

4. Folie nach Anspruch 1, **dadurch gekennzeichnet, dass** als Stabilisator der Formel 1 solche der CAS-Reg.Nr. 36443-68-2 oder CAS-Reg.Nr. 90498-90-1 eingesetzt werden.

5. Folie nach einem der Ansprüche 1 bis 4, **dadurch gekennzeichnet, dass** die Mischung einen Alkalititer von 2 - 70 aufweist.

6. Folie nach einem der Ansprüche 1 bis 5, **dadurch gekennzeichnet, dass** die Mischung zusätzlich 0,001 bis 1 Gew.% nicht-aromatische Lichtstabilisatoren von HAS/HALS/NOR-HALS-Typ enthält.

7. Folie nach einem der Ansprüche 1 bis 6, **dadurch gekennzeichnet, dass** die Mischung zusätzlich phenolische Antioxidantien mit einem Molekulargewicht von weniger als 300 g/mol in einer Menge von 0.001 - 0.25 Gew.% enthält.

8. Folie nach einem der Ansprüche 1 bis 7, **dadurch gekennzeichnet, dass** die Folie einen delta b* - Wert von weniger als 3 besitzt.

9. Verwendung der Folie gemäß den Ansprüchen 1 bis 8 zur Herstellung von Verbundglaslaminaten, Windschutzscheiben oder Photovoltaikmodulen.

## Claims

1. A film of a thermoplastic mixture containing at least one polyvinyl butyral and at least one plasticizer, **characterized by** the addition of 0.001 to 1 wt% of at least one compound according to formula 1: 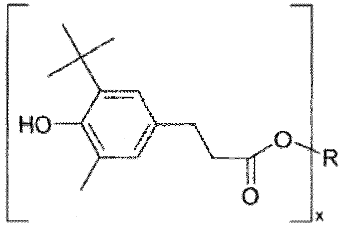 where R = a hydrocarbon radical of a polyfunctional alcohol, a bifunctional cyclic ether, a bifunctional cyclic diether, a bifunctional dioxane derivative, oligoglycols with 1 to 10 glycol units or a hydrocarbon radical with 1 to 20 carbon atoms, and X = 1, 2, 3 or 4 as a stabilizer,
and a plasticizer whose polarity, expressed by the formula 100 x O/(C+H), is less than or equal to 9.4, where O, C and H stand for the number of oxygen, carbon and hydrogen atoms in the respective molecule, where the film has a natural colour DYI of less than 5, determined according to the method of the description.

2. The film according to Claim 1, **characterized in that** a stabilizer of formula 1a below: 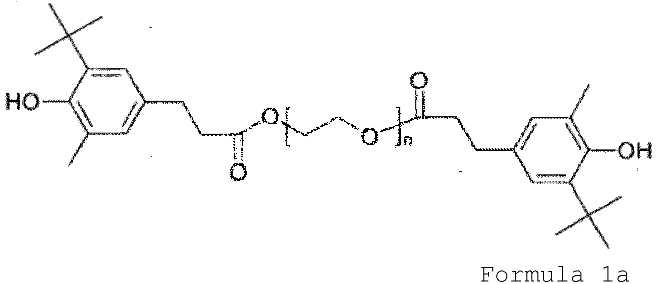 where n = 1 to 10,
is used as the stabilizer of formula 1.

3. The film according to Claim 1, **characterized in that** the stabilizer of formula 1b below: 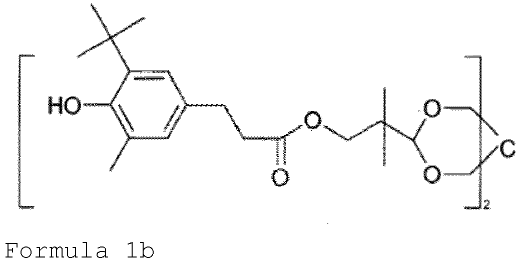 is used as the stabilizer of formula 1.

4. The film according to Claim 1, **characterized in that** the stabilizer of formula 1 that is used is one according to CAS Reg. No. 36443-68-2 or CAS Reg. No. 90498-90-1.

5. The film according to any one of Claims 1 to 4, **characterized in that** the mixture has an alkali titer of 2-70.

6. The film according to any one of Claims 1 to 5, **characterized in that** the mixture additionally contains 0.001 to 1 wt% nonaromatic light stabilizers of the HAS/HALS/NOR-HALS type.

7. The film according to any one of Claims 1 to 6, **characterized in that** the mixture additionally contains phenolic antioxidants with a molecular weight of less than 300 g/mol in an amount of 0.001-0.25 wt%.

8. The film according to any one of Claims 1 to 7, **characterized in that** the film has a delta b* value of less than 3.

9. Use of the film according to Claims 1 through 8 for production of compound glass laminates, windshields or photovoltaic modules.

## Revendications

1. Feuille réalisée à partir d'un mélange thermoplastique contenant au moins un polyvinyle de butyral et au moins un plastifiant, **caractérisée par** l'ajout de 0,001 à 1 % en poids d'au moins un composé selon la formule 1 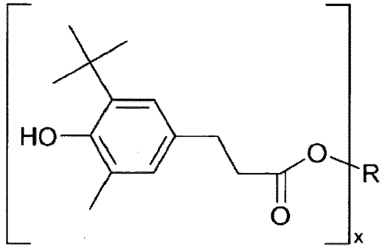 dans laquelle R = radical hydrocarboné issu d'un alcool polyfonctionnel, éther cyclique bifonctionnel, diéther cyclique bifonctionnel, dérivé de dioxane bifonctionnel, oligoglycols comportant 1 à 10 unités de glycols, ou radical hydrocarboné comportant 1 à 20 atomes de carbone, et X = 1, 2, 3 ou 4, en tant que stabilisateur
et plastifiant dont la polarité, exprimée par la formule 100 x O/(C+H), est inférieure ou égale à 9,4 si O, C et H représentent le nombre d'atomes d'oxygène, de carbone et d'hydrogène dans la molécule concernée,
ladite feuille présentant un indice de couleur propre DYI inférieur à 5, déterminé selon la méthode détaillée dans la description.

2. Feuille selon la revendication 1, **caractérisée en ce qu'**en tant que stabilisateur de formule 1, on met en oeuvre ceux répondant à la formule la 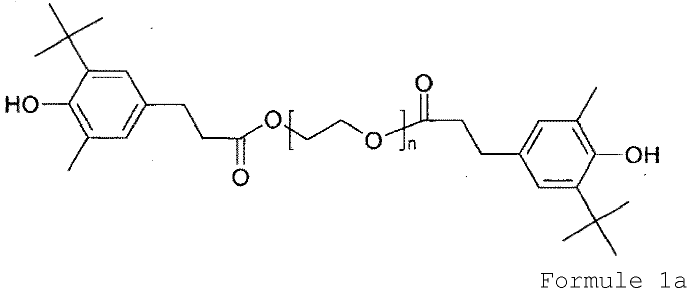 n étant compris entre 1 et 10.

3. Feuille selon la revendication 1, **caractérisée en ce qu'**en tant que stabilisateur de formule 1, on met en oeuvre ceux répondant à la formule 1b

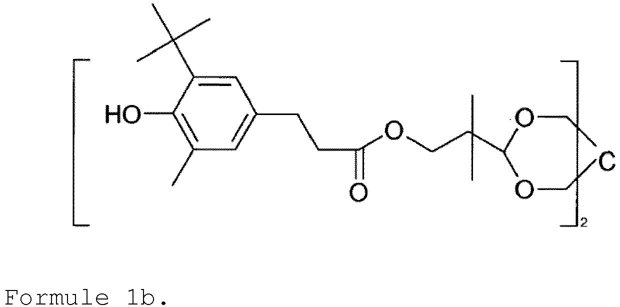

4. Feuille selon la revendication 1, **caractérisée en ce qu'**en tant que stabilisateur de formule 1, on met en oeuvre ceux ayant le n° d'enregistrement CAS 36443-68-2 ou le n° d'enregistrement CAS 90498-90-1.

5. Feuille selon l'une des revendications 1 à 4, **caractérisée en ce que** ledit mélange présente un titre alcalimétrique compris entre 2 et 70.

6. Feuille selon l'une des revendications 1 à 5, **caractérisée en ce que** ledit mélange contient en outre 0,001 à 1 % en poids de photostabilisants non-aromatiques de type HAS/HALS/NOR-HALS.

7. Feuille selon l'une des revendications 1 bis 6, **caractérisée en ce que** ledit mélange contient en outre, dans une quantité comprise entre 0,001 et 0,25 % en poids, des antioxydants phénoliques ayant une masse moléculaire inférieure à 300g/mol.

8. Feuille selon l'une des revendications 1 à 7, **caractérisée en ce que** la feuille présente une valeur delta b* inférieure à 3.

9. Utilisation de la feuille selon les revendications 1 à 8 pour fabriquer des éléments de verre feuilleté, des pare-brise ou des modules photovoltaïques.
